# EUROPEAN PATENT SPECIFICATION

(11) **EP 1 280 007 B1**
(45) Date of publication and mention of the grant of the patent: **18.06.2008**
(21) Application number: 02255177.4
(22) Date of filing: 24.07.2002
(51) Int. Cl.: G03F 7/20

(54) **Imaging apparatus**
Bilderzeugungsapparat
Appareil pour la production des images

(30) Priority: 24.07.2001 EP 01202825
(43) Date of publication of application: 29.01.2003
(73) Proprietor: ASML Netherlands B.V., 5504 DR Veldhoven (NL)
(72) Inventor: Bleeker, Arno Jan, 5563 CE Westerhoven (NL); De Jager, Pieter Willem Herman, 3063 TB Rotterdam (NL); Hintersteiner, Jason Douglas, Bethel CT 06801 (US); Kruizinga, Borgert, 2725 HC Zoetermeer (NL); McCarthy, Matthew Eugene, Brookfield CT 06804 (US); Oskotsky, Mark, Mamaroneck, NY 10543 (US); Ryzhikov, Lev, Norwalk, CT 06851 (US); Sakin, Lev, Stamford, CT 06902 (US); Smirnov, Stanislav, Bethel, CT (US); Snijders, Bart, 3053 KP Rotterdam (NL); Van Der Mast, Karel Diederick, 5708 BB Stiphout-Helmond (NL)
(74) Representative: Leeming, John Gerard

(56) References cited:
- EP-A- 0 573 375
- EP-A- 0 811 499
- WO-A-02/48797
- WO-A-02/101888
- DE-A- 19 534 165
- US-A- 4 497 013
- US-A- 5 016 149
- US-A- 5 029 243
- US-A- 5 153 773
- US-B1- 6 184 490
- US-B1- 6 233 039

## Description

The present invention relates to an imaging apparatus comprising:
- a radiation system for supplying a projection beam of radiation;
- a support structure for supporting programmable patterning means, the programmable patterning means serving to pattern the projection beam according to a desired pattern;
- a substrate table for holding a substrate; and
- a projection system for projecting the patterned beam onto a target portion of the substrate.

The term "programmable patterning means" as here employed should be broadly interpreted as referring to programmable means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such programmable patterning means include:
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required.
- A programmable LCD array. An example of such a construction is given in United States Patent US 5,229,872, which is incorporated herein by reference. As above, the support structure in this case may be embodied as a frame or table, for example, which may be fixed or movable as required.

An imaging apparatus as specified in the opening paragraph is currently employed to make mask writing machines, e.g. by the firm Micronic in Sweden. Such a mask can be used in a lithographic projection apparatus, which repetitively images the mask pattern onto a photo-sensitive substrate - such as a photoresist-coated silicon wafer - as part of the broader manufacturing process involved in producing integrated devices, such as integrated circuits (ICs). The substrate in such a mask writing machine is, for example, a metallized plate (e.g. a Cr-coated quartz or CaF₂ plate) that has been coated with a layer of photoresist. The idea behind such a mask writing machine is that an electronic file of the (highly complex) mask pattern is used to matrix-address the patterning means, which then divert a patterned radiation beam onto a small portion of the mask plate. By changing the pattern in the patterned beam in accordance with the electronic file, and concurrently moving the beam over the whole surface of the mask plate (in either a scanning or a stepping motion), the final mask pattern is built up as a sum of combined (juxtaposed) sub-patterns from the patterned beam. For this reason, such a machine is sometimes referred to as a "mask writer".

Although machines as described in the previous paragraph have heretofore been used only in the manufacture of masks, it is - at least in principle - possible to use them in the manufacture of semiconductor and other integrated devices. In such a case, the mask plate would be replaced by, for example, a Si wafer, and the pattern built up on the wafer by the patterning means would correspond to an array of die patterns. However, a major drawback of such an application would be its very low throughput: whereas current direct-write machines might be expected to achieve a throughput of the order of one substrate per day, a state-of-the-art lithographic projection apparatus has a throughput of the order of 100 substrates per hour. Nevertheless, it might still be interesting to pursue such an application: for example, in the case of a foundry making a small batch of a particular integrated device (such as a dedicated ASIC), it might be more attractive to endure a slow direct-write process as delivered by a machine as described above rather than to entail the very high costs (often of the order of 50-100 thousand U.S. dollars) of making a special mask for the batch in question. At the moment, such a choice might only be attractive in the case of a very small batch of a very expensive device; however, it would become much more attractive if the throughput of direct-write machines could be increased. More information with regard to conventional lithographic apparatus as here described can be gleaned, for example, from US 6,046,792, incorporated herein by reference.

It is an object of the present invention to provide an apparatus as described in the opening paragraph, which apparatus has a greatly improved throughput as compared to prior art apparatus in the same technological area. Furthermore, it is an object of the invention that such an apparatus should be usable to manufacture integrated circuits and other (semiconductor) devices, as a commercially attractive alternative to the use of a conventional lithographic projection apparatus (employing a mask) for this purpose.

This and other objects are achieved according to the invention in an imaging apparatus as defined in the appended claims.

Because the apparatus according to the invention employs a plurality of patterning sub-elements - each of which may, for example, be as large as the whole patterning means in a prior art direct-write apparatus - and because the sub-beams from these sub-elements are combined to produce a composite image, the throughput of the whole is very much improved over that of a prior art apparatus. This is a much more satisfactory approach that attempting to increase the size of a (single) patterning means, since such a size increase would be accompanied by very significant (if not insurmountable) manufacturing difficulties; in particular, the chance that a mirror array, for example, would contain one or more defective mirror "pixels" would increase dramatically as the size of the array increased, leading to a drastically reduced yield and, thus, significantly increased manufacturing costs. Moreover, it is generally easier to supply data (for matrix-addressing purposes) to a plurality of patterning sub-elements according to the invention than it is to supply such data to a single, enlarged patterning means.

The Embodiments below discuss various ways of implementing the apparatus according to the invention. It should be stressed that the inventive apparatus can not only be used in the manufacture of (semiconductor) devices with a heightened throughput: it can, of course, also be used to write masks at greatly increased speed.

According to a further aspect of the invention there is provided a device manufacturing method as defined in the appended claims.

In a (semiconductor) manufacturing process using an imaging device as here described, a device pattern is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Twin stage lithographic apparatus are described, for example, in US 5,969,441 and WO 98/40791, incorporated herein by reference.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, DNA analysis devices, etc. The skilled artisan will appreciate that, in the context of such alternative applications, any use of the terms "wafer" or "die" in this text should be considered as being replaced by the more general terms "substrate" and "target portion", respectively.

In the present document, the terms "radiation" and "beam" are used to encompass all types of electromagnetic radiation, including ultraviolet radiation *(e.g.* with a wavelength of 365, 248, 193, 157 or 126 nm) and EUV (extreme ultra-violet radiation, *e.g.* having a wavelength in the range 5-20 nm).

Embodiments of the invention will now be described, by way of example only, with reference to the accompanying schematic drawings in which:
Figure 1 depicts an imaging apparatus pertinent to the invention;
Figure 2 depicts part of the optical system of a first embodiment of the invention;
Figure 3 depicts part of the optical system of a second embodiment of the invention;
Figure 4 depicts part of the optical system of a third embodiment of the invention;
Figure 5 depicts part of the optical system of a fourth embodiment of the invention;
Figure 6 depicts part of the optical system of a fifth embodiment of the invention;
Figure 7 depicts part of the optical system of a sixth embodiment of the invention;
Figure 8 depicts part of the optical system of a seventh embodiment of the invention;
Figure 9 depicts part of the optical system of a eighth embodiment of the invention;
Figure 10 depicts part of the optical system of a ninth embodiment of the invention;
Figure 11 depicts a scanning scheme of a tenth embodiment of the invention;
Figure 12 depicts the arrangement of plural programmable patterning means in an eleventh embodiment of the invention;
Figure 13 illustrates the segmented lens concept of the eleventh embodiment;
Figure 14 depicts the arrangement of plural programmable patterning means in a twelfth embodiment of the invention;
Figure 15 depicts the arrangement of plural programmable patterning means in a thirteenth embodiment of the invention;
Figure 16 depicts the arrangement of plural programmable patterning means in a fourteenth embodiment of the invention;
Figure 17 depicts the arrangement of plural programmable patterning means in a fifteenth embodiment of the invention;
Figure 18 depicts the arrangement of plural programmable patterning means in a sixteenth embodiment of the invention;
Figure 19 depicts the arrangement of plural programmable patterning means in a seventeenth embodiment of the invention;
Figure 20 depicts the arrangement of plural programmable patterning means in a eighteenth embodiment of the invention;
In the Figures, corresponding reference symbols indicate corresponding parts.

### Example

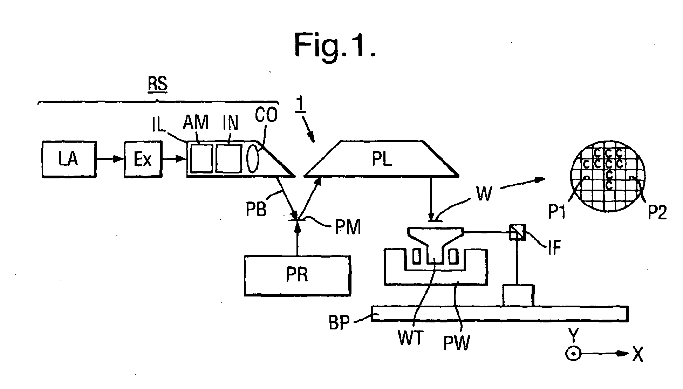

Figure 1 schematically depicts an imaging apparatus in conjunction with which the current invention can be employed. The apparatus comprises:
- a radiation system RS for supplying a projection beam PB of radiation (*e.g.* UV or EUV radiation). In this particular case, the radiation system comprises a radiation source LA, a beam expander Ex and an illumination system including adjusting means AM for setting an illumination node, an integrator IN and condensing optics CO;
- patterning means PM, comprising a Spatial Light Modulator (SLM) and pattern rasterizer PR (for matrix-addressing the SLM);
- a substrate table WT for holding a substrate W (*e.g.* a resist-coated silicon wafer), and connected to interferometric measurement and positioning means IF for accurately positioning the substrate with respect to item PL;
- a projection system ("lens") PL (*e.g.* a refractive lens system) for imaging the beam PB onto a target portion C (*e.g.* comprising one or more dies) of the substrate W. A

It should be noted with regard to Figure 1 that the source LA may be within the housing of imaging apparatus, but that it may also be remote from the lithographic projection apparatus, the radiation beam which it produces being led into the apparatus, e.g. with the aid of suitable directing mirrors. The current invention and Claims encompass both of these scenarios.

Having traversed the SLM, the beam PB passes through the lens PL, which focuses the beam PB onto a target portion C of the substrate W. With the aid of the interferometric measuring and positioning means IF, the substrate table WT can be moved accurately, *e.g.* so as to position different target portions C in the path of the beam PB. In general, movement of the substrate table WT will be realized with the aid of a long-stroke module (coarse positioning) and a short-stroke module (fine positioning), which are not explicitly depicted in Figure 1. The substrate W may, for example, a quartz plate onto which a mask pattern is to be written, or a silicon wafer onto which an array of device dies is to be imaged.

### Embodiment 1

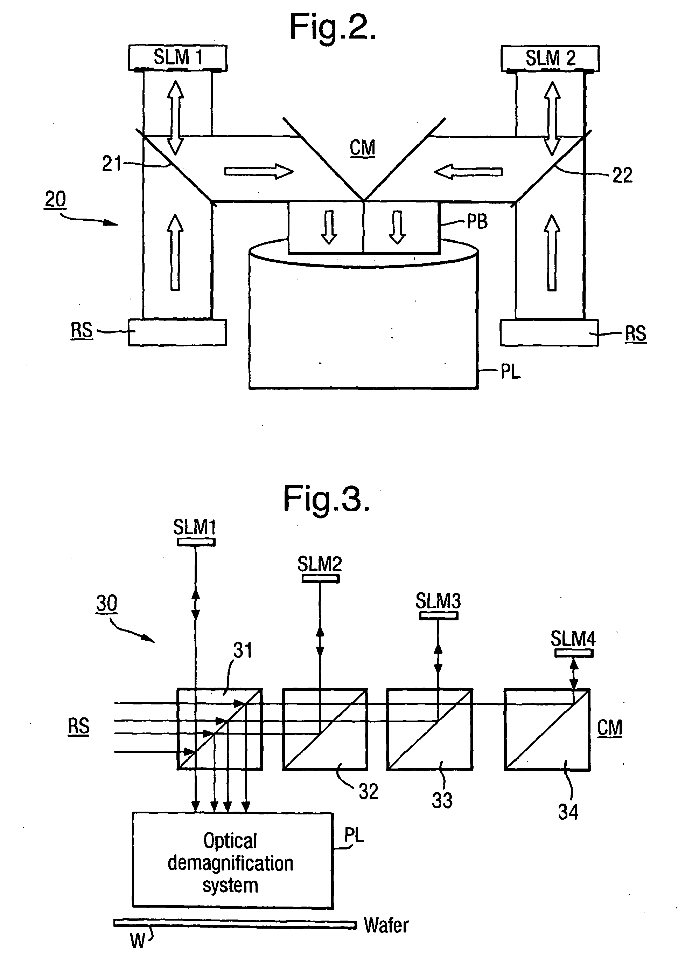

Figure 2 depicts part of a first embodiment of an imaging apparatus 20 according to the present invention.

Light from the radiation system RS is directed onto two spatial light modulators SLM1, SLM2, via beam splitters 21, 22. The patterned light reflected from the two spatial light modulators SLM1, SLM2 is then directed by the beam splitters 21, 22 onto combining means CM. In this instance, the combining means CM take the form of reflectors that direct the sub-beams from the separate SLMs and combine them into a single beam PB. By introducing additional optics in the beam paths between the SLMs and the (demagnifying) projection system PL, the patterned sub-beams can be made smaller at the entrance of the projection system; this will create more space for the mirror system CM, and also for the SLMs. Also, the sub-beam branches do not have to be at the same height; this again allows more space to be created for the mirror optics. For the sake of simplicity, only two SLM branches are shown in this Figure; however, more can be added if desired.

### Embodiment 2

Figure 3 depicts part of a second embodiment of an imaging apparatus 30 according to the present invention

The Figure shows a possible way to combine the sub-beams from four spatial light modulators SLM1 to SLM4 into a single image, though the same principle can be extended to numbers other than four. In this case, the combining means CM comprise an array of beam-splitting mirror blocks 31- 34. The optical path length between each SLM and the demagnifying projection system PL should be the same if no additional optical elements are used. Introduction of optical elements between the SLMs and mirror blocks and/or between the mirror blocks 31-34 themselves can add design flexibility.

### Embodiment 3

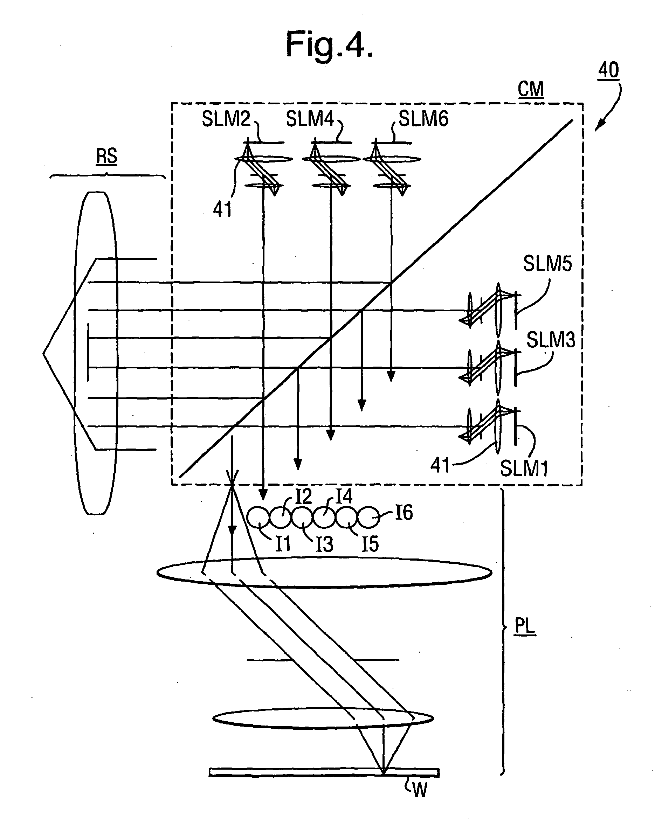

Figure 4 depicts part of a third embodiment of an imaging apparatus 40 according to the present invention.

The spatial light modulators SLM1 to SLM6 are arranged in two rows that have been placed in the two paths of a beam splitter, acting as combining means CM. The reflected beams from the spatial light modulators SLM1 to SLM6 are combined such that the structures are aligned at what would be the plane of the mask in a conventional lithographic projection apparatus. An intermediate image is created at this plane, allowing the projection optics PL of the apparatus to be used. For each of the spatial light modulators SLM1 to SLM6, an optical system 41 is provided to create the images I1 to I6 at the object plane of the projection system PL.

If the mirrors of the SLM have to be demagnified by a factor of, say, 320, a factor of 4 (for example) is realized in the projection optics PL. The remaining demagnification factor 80 can then be realized in the optical system 41 of each of the channels for the individual spatial light modulators SLM1 to SLM6. Moreover, the contrast aperture (spatial filter) can be placed in these sub-beams.

### Embodiment 4

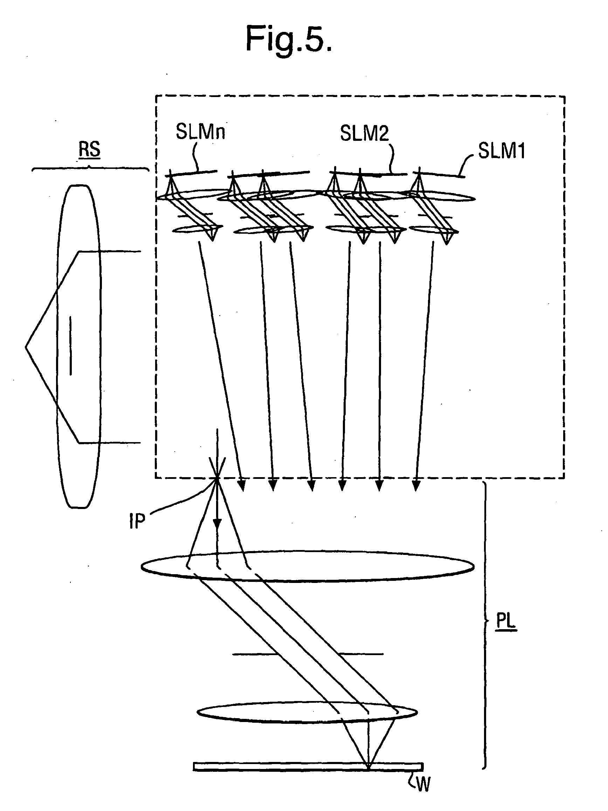

Figure 5 depicts part of the operation of a fourth embodiment of an imaging apparatus according to the present invention.

The spatial light modulators SLM1 to SLM-n are positioned in a fan configuration. The images of the SLMs are formed in a plane IP at what would be the position of the mask in a conventional lithographic projection apparatus. With Scheimpflug optics in the optical system connected to each SLM, it is possible to create an image in a plane even though the objects themselves (the SLMs) are not in a plane.

Several fans can be positioned in this scenario (e.g. perpendicular to the plane of the drawing). Two fans have been indicated in the drawing, but more levels are possible. In general, the SLMs are positioned on a ball-shaped surface.

A projection optics system PL re-images the images in plane IP onto the substrate W, e.g. with a reduction by a factor of 4.

The third and fourth embodiments can be combined. The layout of the system within the dotted box of Figure 5 then consists of a central beam splitter, with spatial light modulators positioned both above and to the right on respective curved surfaces. An optical system is positioned directly below/beside each SLM, consisting of at least Scheimpflug optics and a filter aperture.

Calculation example for filling the entire width of a die in a single scan:
- 25 mm at wafer with 100 nm pixels, 250 x 10³ pixels
- Each pixel is printed with 2 mirrors in each direction, 500 x 10³ mirrors in non-scan direction
- State-of-the-art SLMs have 2048x512 mirrors, so at least 250 SLMs have to be combined
- This means 125 in each of the two directions of the beam splitter.
- If positioned in a row, this would mean a row of more than 8 meters (16 µm mirrors and 50% of the chip area filled with mirrors). Not a very practical solution.
- Supposing 10 curved levels, an area of about 80x80 cm² is filled with SLMs, with a packing density of 50%. This is of more practical use.
- The slit width during scanning is about 25 µm.

### Embodiment 5

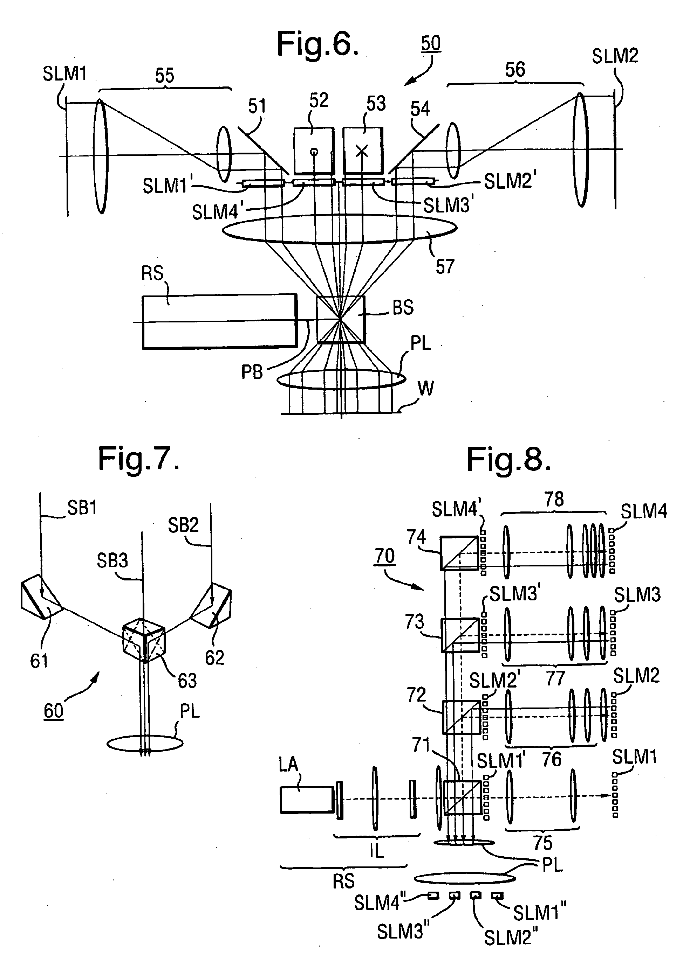

Figure 6 depicts part of a lithographic apparatus 50 according to a fifth embodiment of the invention which uses four spatial light modulators. The projection beam PB provided by radiation system RS is directed by beam splitter BS into coupling lens CL which expands the beam. Four folding mirrors 51-54 then direct radiation into separate optical channels for each of the spatial light modulators. For clarity, only two spatial light modulators SLM1, SLM2 and their respective optical channels 55,56 are shown. The third and fourth spatial light modulators and their optical channels are positioned below and above the page of the drawing. The separate optical channels 55,56 focus the patterned beams reflected by the spatial light modulators to form reduced images SLM1'-SLM4' adjacent each other in a plane. Those images are then re-imaged on the substrate W by coupling lens 57 and the projection lens PL, with a further reduction.

### Embodiment 6

Figure 7 depicts a part of the optical system 60 of a lithographic apparatus according to a sixth embodiment which is adapted to combine three sub-beams with low intensity losses. The three patterned sub-beams SB1-SB3 are combined by three-way beam splitter 63, sub-beams SB 1 and SB2 having been directed into side faces of three-way beamsplitter TS by folding mirrors 61,62. This arrangement minimizes the number of reflections to combine three beams and hence minimizes reflection and polarization losses.

### Embodiment 7

Figure 8 depicts part of the optical system 70 of a seventh embodiment which is similar to the third embodiment in using beamsplitters 71-74 to combine the patterned sub-beams from four spatial light modulators SLM1-SLM4.

The radiation system RS, comprising source LA, e.g. an excimer laser, and illumination system IL, delivers a collimated projection beam PB, which is split and directed onto the spatial light modulators SLM1-SLM4 by the beam splitters 71-74. The reflected, patterned sub-beams are imaged as SLM1'-SLM4' by separate optical systems 75-78 at the entrances to the respective ones of the beam splitters 71-74. The separate optical system 75-78 compensate for the different optical path lengths of the different branches of the system and may include some reduction, *e.g.* by 16 or 20.

The projection system PL then re-images the images SLM' - SLM4' with a reduction on the substrate as SLM 1 "-SLM4", *e.g.* by 16 or 20.

### Embodiment 8

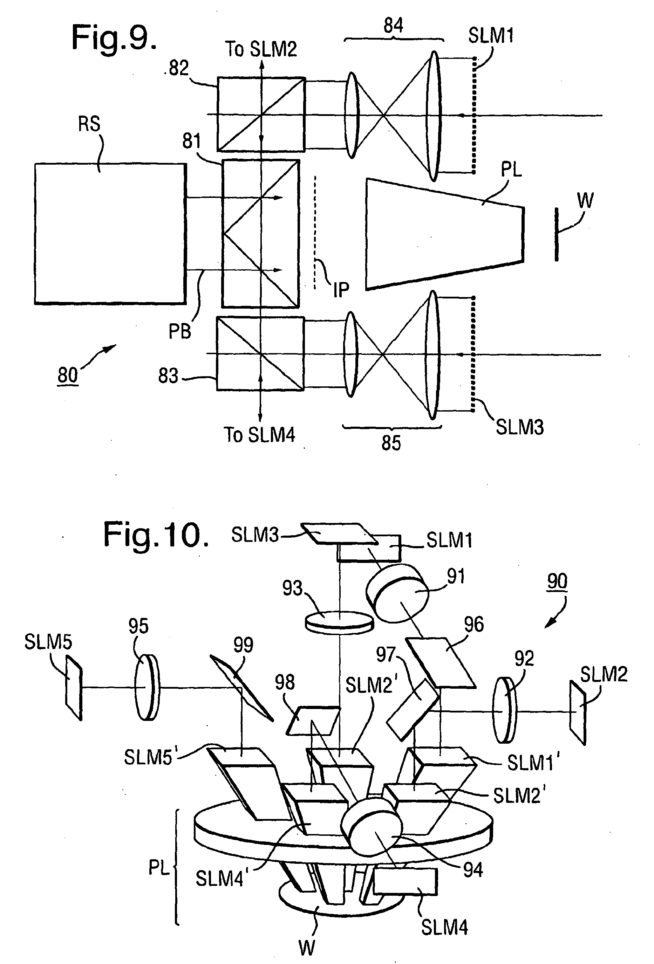

Figure 9 depicts part of the optical system 80 of an eighth embodiment of the invention which is arranged so that each branch involves the same number of passes through beam splitters.

The projection beam PB output by radiation system RS is divided in two by first beam splitter 81. The two sub-beams produced by beamsplitter 81 are each further divided in two by second and third beamsplitters 82, 83 and directed to the spatial light modulators SLM1-SLM4 (for clarity only SLM1 & SLM3 are shown). The patterned sub-beams returning from the spatial light modulators are re-imaged by respective relay systems 84, 85 (only two shown for clarity) via the beam splitters 81-83 in an image plane IP, which also forms the object plane of the projection lens PL. The relay systems 84, 85, which form separate optical channels for the respective spatial light modulators, preferably reduce the images of the spatial light modulators; further reduction is effected in the projection system PL.

### Embodiment 9

Figure 10 depicts a part of the optical system 90 of a lithographic projection apparatus according to a ninth embodiment of the invention. Five spatial light modulators SLM1-SLM5 are used and have respective optical systems 91-95 and folding mirrors 96-99 that create images SLM1'-SLM5' in the object plane of projection system PL. The projection system PL projects a reduced image of the spatial light modulators SLM1-SLM5 on to the substrate W.

### Embodiment 10

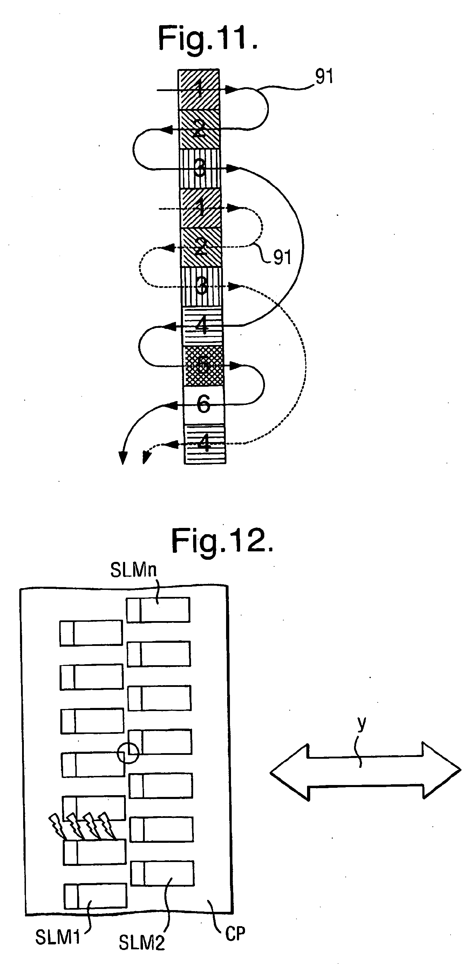

In a tenth embodiment, which may employ an optical system as used in any of the embodiments described above, the spatial light modulators, respective optical systems and projection system, PL are arranged so that on the substrate, the gap between images of the spatial light modulators is exactly equal to an integer multiple of the height of a spatial light modulator. A lithographic apparatus of the tenth embodiment therefore uses a scanning scheme explained with reference to Figure 11. Figure 11 illustrates a scanning scheme for an apparatus with two spatial light modulators and where the images of the spatial light modulators are spaced apart by two array widths on the substrate. The substrate is moved along a meander path such that the images of the spatial light modulators follow the paths labeled 90, 91 in the figure. Thus first the two target areas labeled 1 are imaged, then the adjacent areas labeled 2, then the areas labeled 3 to fill the gap between the two areas first imaged. Next, the substrate is stepped by a distance equal to four times the width of an image of one of the spatial light modulators so that areas 4 are imaged. The cycle then repeats to image areas 5 and 6, etc..

### Embodiment 11

Figure 12 depicts a carrier plate CP holding multiple spatial light modulators SLM1- SLMn in an eleventh embodiment of an imaging apparatus according to the present invention. Each of the spatial light modulators consists of, for example, an array of 3,000 by 1,000 mirrors, each 4µm square.

The working of the combining means in this instance is such that the SLMs are placed on a carrier plate CP and imaged onto a substrate with a conventional projection system (not depicted). By arranging the SLMs on the carrier plate in a staggered pattern, the full area of the substrate can be exposed. Adjacent rows of spatial light modulators are placed so that there is an overlap between SLMs in the direction perpendicular to the scanning direction Y. The size of the overlap is determined by the placement accuracy of the SLMs. The substrate image is preferably built up from a number of sub-exposures (e.g. 4), so as to reduce the possible effects of dose errors. Accordingly, the radiation source is pulsed every time the carrier plate has moved one quarter of the length of the SLM. For the final group of pixels in each SLM, the illumination is attenuated to allow control of the dose delivered at substrate level. The optical field is limited by the maximum radius of the first lens element in front of the SLM; in the case of conventional lithographic projection apparatus lenses, this value will be of the order of about 10 cm.

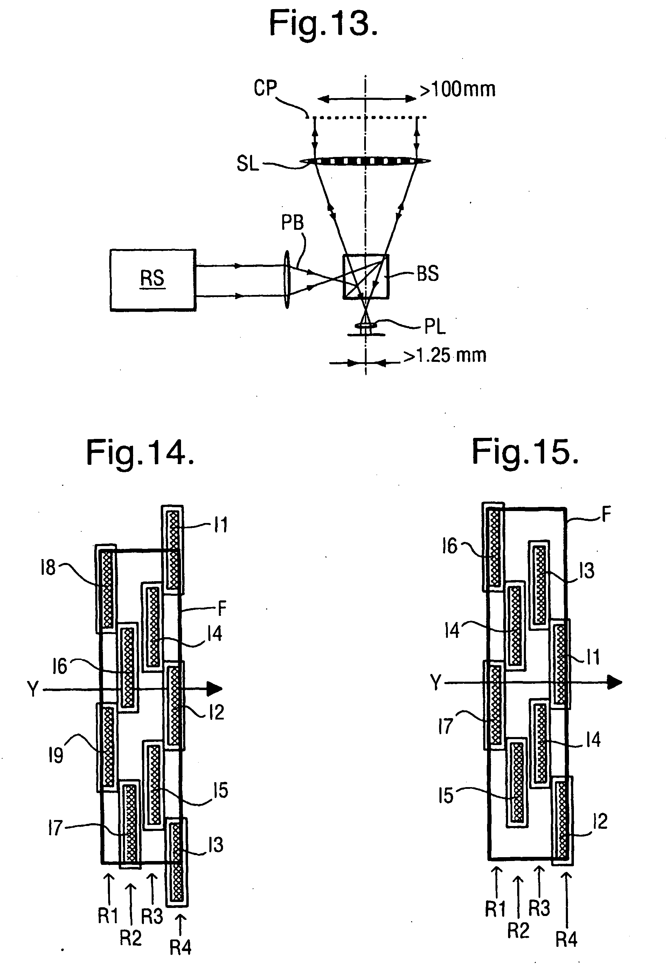

Since not all the area of the carrier plate CP is used, and because the opening angle at each spatial light modulator is small, it is possible to segment the first lens in the projection system PL, thus reducing the size and amount of refractive material (e.g. quartz or CaF₂) needed. Figure 13 shows this concept in more detail. The plate CP carrying the spatial light modulator may have a dimension of 100mm or more but the active parts of the spatial light modulators cover only small parts of the total area of the plate. Rather than have a large lens with a field of view covering the entire plate CP, the lens SL which collects the radiation from the spatial light modulators is segmented and only those parts necessary to collect radiation from the spatial light modulators are provided. Because the numeric aperture of the illumination radiation for radiation source LS is small, the segments of the lens provided are only a small part of the whole lens. Were the whole lens to be provided, the parts omitted in the segmented lens would have little or no useful radiation passing through them.

The segmented lens SL both expands the projection beam PB from the radiation system and also reduces the patterned beam from the spatial light modulators so that the beam splitter BS and projection system PL can be comparatively small in size.

Of course, two or more segmented lenses may be used, depending on how quickly the sub-beams from the spatial light modulators diverge and are brought together in the optical system.

The carrier plate of the eleventh embodiment, carrying multiple spatial light modulators, may be used in place of the single spatial light modulators in any of the above described embodiments.

### Embodiment 12

In a twelfth embodiment of the present invention, which may make use of the optical arrangements of any of the above embodiments, the images of the spatial light modulators are arranged as shown in Figure 14.

As can be seen in Figure 14, images I1 to I8 are arranged in four rows R1-R4. The rows are staggered and the separation between images is less than the length of the images so that the full width of the imaged field F in the direction perpendicular to the scanning direction Y is covered. In the first and second and third and fourth rows, the top and bottom of the images are aligned. The second and third rows R2, R3 ensure that the whole of the target area is imaged on twice, to improve uniformity and eliminate seams. During an exposure, the radiation source is pulsed one or more times every time the substrate advances a distance equal to the row spacing.

The arrangement shown in the Figure can be achieved in two ways. Firstly, the spatial light modulators can be arranged on a carrier plate in the corresponding layout. In that case, the hatched area represents the active area of each spatial light modulator and the box around it the necessary mounting margin and inactive area. The field F represents the illumination field on the carrier plate, defined by masking blades.

Alternatively, the depicted arrangement can be achieved with spatial light modulators arranged as convenient and their images brought to the object plane of the projection system PL in the layout depicted. In this case, each of the hatched areas in the picture may be an image of an array of spatial light modulators rather than just one spatial light modulator so that there is effectively an array of arrays.

### Embodiment 13

Figure 15 shows the thirteenth embodiment of the invention, which is a variant of the twelfth embodiment and may be put into practice in the same ways. The thirteenth embodiment differs from the twelfth in using one fewer spatial light modulator (or array of spatial light modulators). Images I2 and I6 are aligned with the edges of field F. Although one spatial light modulator is saved, the edge parts of the field are only imaged once in the scan.

### Embodiment 14

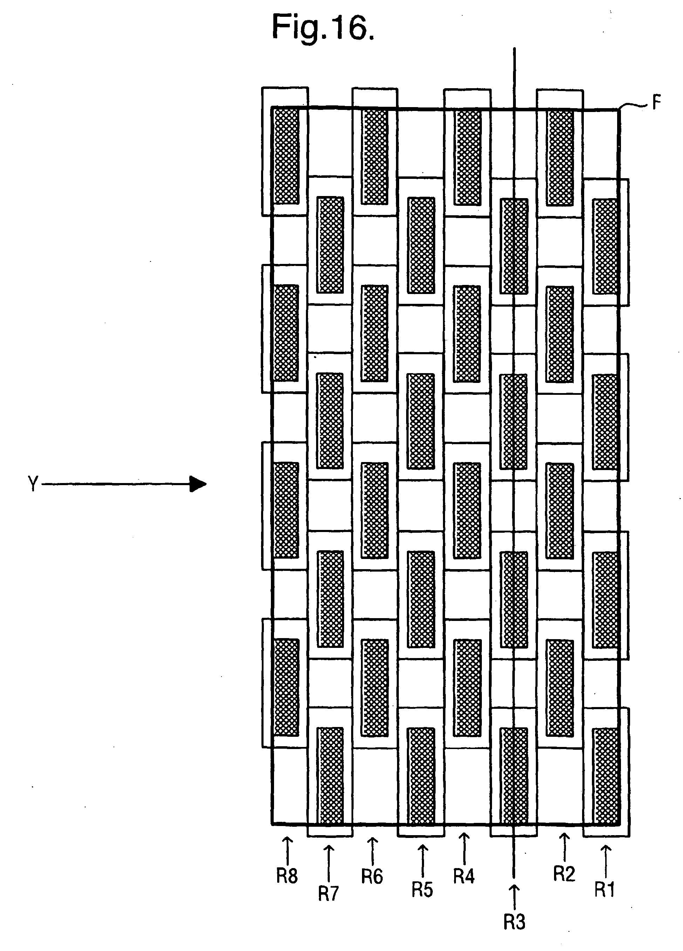

The fourteenth embodiment uses a further alternative arrangement of images, depicted in Figure 16 that can be achieved in the same ways as the twelfth embodiment. In this case, the images are arrayed in eight rows and is particularly suitable where the spatial light modulators have larger inactive areas and mounting margins.

### Embodiment 15

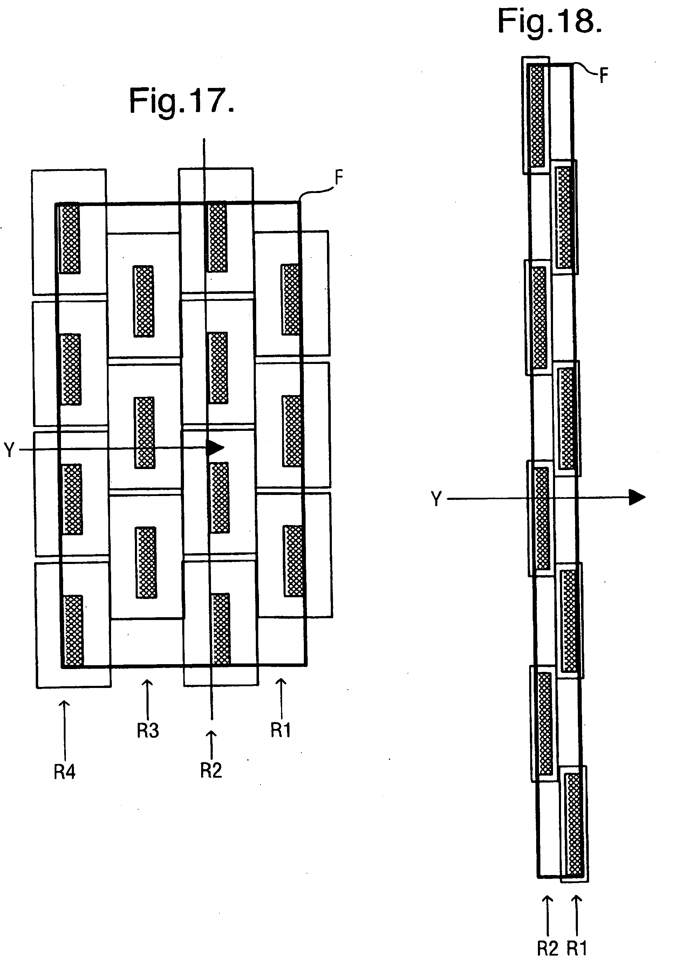

The fifteenth embodiment is particularly applicable where the active areas of the spatial light modulators are contained in large packages and can make use of off-the-shelf spatial light modulators with little or no modification. As Figure 17 shows, four rows R1-R4 of images are used with the tops and bottoms of the active areas of adjacent spatial light modulators aligned. The fifteenth embodiment can be effected in the same way as the twelfth embodiment.

### Embodiment 16

Figure 18 shows the arrangement of images in a sixteenth embodiment which again can be effected in the same way as the thirteenth embodiment. In the seventeenth embodiment, only two rows R1, R2 of images are used to span the field F, which is relatively long and narrow. The sixteenth embodiment minimizes the number of spatial light modulators necessary at the expense of throughput.

### Embodiment 17

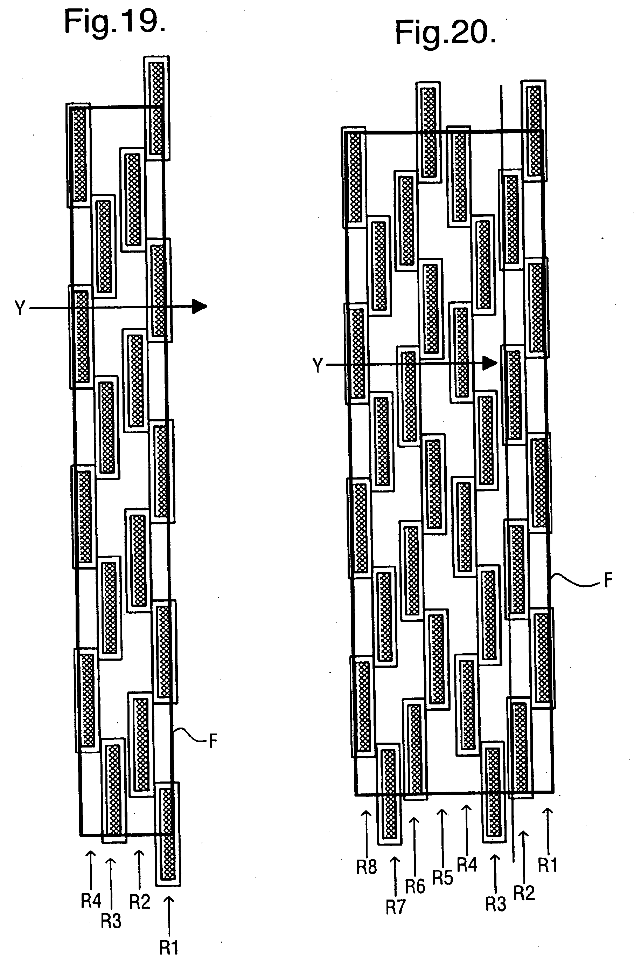

A seventeenth embodiment uses an arrangement of images as shown in Figure 19. Using four rows of images R1-R4, a relatively wide field F can be imaged with higher throughput than in the sixteenth embodiment whilst the displacement of the third and fourth rows relative to the first and second rows eliminates seams.

### Embodiment 18

An eighteenth embodiment of the present invention maximizes throughput by using eight rows R1-R8 of images to cover a large field F, as shown in Figure 20.

Whilst specific embodiments of the invention have been described above, it will be appreciated that the invention may be practiced otherwise than as described. The description is not intended to limit the invention.

## Claims

1. An imaging apparatus comprising:
- a radiation system (IL) for providing a projection beam of radiation;
- programmable patterning means (PM), the patterning means serving to pattern the projection beam according to a desired pattern;
- a substrate table (WT) for holding a substrate;
- a projection system (PL) for projecting the patterned beam onto a target portion of the substrate,
**characterized in that**:
- the programmable patterning means comprise a plurality of separate spatial light modulators (SLM1, etc.), each of which is used to generate a patterned sub-beam; and
- the apparatus comprises combining means (CM) comprising a beam splitter for combining the plurality of patterned sub-beams into a single patterned image that is larger than the image of any one of the spatial light modulators.

2. An imaging apparatus according to claim 1 wherein said combining means (CM) comprises a plurality of separate optical channels, one for each of said separate spatial light modulators, for projecting an image of a respective one of said separate spatial light modulators into an object plane of said projection system

3. An imaging apparatus according to claim 3, wherein said plurality of separate optical channels are arranged to project reduced images of said separate spatial light modulators.

4. An imaging apparatus according to claim 1, 2 or 3 wherein said programmable patterning means (PM) comprises first to fourth separate spatial light modulators (SLM1-SLM4) and said combining means comprise first to third beam splitters (31-33), said first beam splitter (33) combining patterned beams from said first and second separate spatial light modulators to form a first combined beam, said second beam splitter (32) combining a patterned beam from said third separate spatial light modulator with said first combined beam to form a second combined beam, and said third beamsplitter combining a patterned beam from said fourth separate spatial light modulator with said second combined beam to form a third combined beam that is projected onto said substrate by said projection system.

5. An imaging apparatus according to claim 1, 2 or 3 wherein said programmable patterning means (PM) comprises first to fourth separate spatial light modulators and said combining means comprise first to third beam splitters (81-83), said first beam splitter (82) combining patterned beams from said first and second separate spatial light modulators to form a first combined beam, said second beam splitter (83) combining patterned beams from said third and fourth separate spatial light modulators to form a second combined beam, and said third beamsplitter (81) combining said first combined beam with said second combined beam to form a third combined beam that is projected onto said substrate by said projection system.

6. An imaging apparatus according to claim 1, 2 or 3 wherein said separate spatial light modulators are arranged around an imaginary circle parallel to said object plane and said separate optical channels each comprises an optical system (55, 56) having an optical axis extending generally radially of said imaginary circle and a folding mirror (51, 54) for directing a beam output by said optical system to intersect said object plane.

7. An imaging apparatus according to claim 1, 2 or 3 wherein said combining means comprises a three-way beamsplitter (63) and two folding mirrors (61,62).

8. An imaging apparatus according to any one of the preceding claims wherein each separate spatial light modulator comprises an array of individually controllable radiation modulating devices.

9. An imaging apparatus according to claim 8 wherein said plurality of separate spatial light modulators are mounted in a staggered array on a carrier plate.

10. An imaging apparatus according to any one of claims 1 to 7 wherein each of said separate spatial light modulators comprises a carrier plate having mounted thereon a plurality of separate arrays of individually controllable radiation modulating devices, said separate arrays being mounted in a staggered array.

11. An imaging apparatus according to claim 8, 9 or 10 wherein each of said individually controllable radiation modulating devices comprises a moveable mirror or a pixel of a liquid crystal device.

12. An imaging apparatus according to any one of the preceding claims further comprising means to scan said substrate in a first direction (Y) during exposure of a target portion and wherein said combining means and said projection system are adapted to project images of said plurality of separate spatial light modulators onto said substrate in a staggered array having at least first and second rows (R1, R2) extending in a second direction perpendicular to said first direction, the lengths of said images in said second direction being greater than the spaces between and the images of said second row being placed behind the spaces of said first row in said first direction.

13. An imaging apparatus according to claim 12 wherein said staggered array further comprises third and fourth rows of images (R3, R4), said third row of images being behind said second row in said first direction and offset from said first row in said second direction by a first offset distance less than the length in said second direction of one of said images, and said fourth row of images being behind said third row in said first direction and offset from said second row in said second direction by said first offset distance.

14. An imaging apparatus according to claim 12 or 13 wherein each of said images of said plurality of separate patterning sub-elements itself comprises a staggered array of images of separate arrays of individually controllable radiation modulating devices.

15. A device manufacturing method comprising the steps of:
- providing a substrate (W) that is at least partially covered by a layer of radiation-sensitive material;
- providing a projection beam (P3) of radiation using a radiation system;
- using programmable patterning means (PM) to endow the projection beam with a pattern in its cross-section;
- projecting the patterned beam of radiation onto a target portion of the layer of radiation-sensitive material,
**characterized in that** the programmable patterning means (PM) comprise a plurality of separate spatial light modulators (SLM1-SLM4), each of which is used to generate a patterned sub-beam, and that the plurality of patterned sub-beams is combined using a beam splitter into a single patterned image on the substrate that is larger than the image of any one of the spatial light modulators.

## Patentansprüche

1. Abbildungsvorrichtung, umfassend:
- ein Strahlungssystem (IL) zum Bereitstellen eines Projektionsstrahls aus Strahlung;
- eine programmierbare Musteraufbringungseinrichtung (PM), wobei die Musteraufbringungseinrichtung dazu dient, den Projektionsstrahl gemäß einem erwünschten Muster zu mustern;
- einen Substrattisch (WT) zum Halten eines Substrats;
- ein Projektionssystem (PL) zum Projizieren des gemusterten Strahls auf einen Zielabschnitt des Substrats,
**dadurch gekennzeichnet, dass**
- die programmierbare Musteraufbringungseinrichtung eine Vielzahl separater, räumlicher Lichtmodulatoren (SLM1, etc.) aufweist, von denen jeder dazu verwendet wird, einen gemusterten Teilstrahl zu erzeugen; und
- die Vorrichtung eine Bündelungseinrichtung (CM) aufweist, die einen Strahlteiler zum Bündeln der Vielzahl gemusterter Teilstrahlen zu einem einzelnen gemusterten Bild, das größer als das Bild von einem der räumlichen Lichtmodulatoren ist, aufweist.

2. Abbildungsvorrichtung nach Anspruch 1, bei der die Bündelungseinrichtung (CM) eine Vielzahl separater optischer Kanäle - jeweils einen für jeden der separaten räumlichen Lichtmodulatoren - aufweist zum Projizieren eines Bildes von jeweils einem der separaten räumlichen Lichtmodulatoren in eine Objektebene des Projektionssystems.

3. Abbildungsvorrichtung nach Anspruch 3, bei der die Vielzahl separater optischer Kanäle derart angeordnet ist, um reduzierte Bilder der separaten räumlichen Lichtmodulatoren zu projizieren.

4. Abbildungsvorrichtung nach Anspruch 1, 2 oder 3, bei der die programmierbare Musteraufbringungseinrichtung (PM) erste bis vierte separate räumliche Lichtmodulatoren (SLM1 - SLM4) aufweist und die Bündelungseinrichtung erste bis dritte Strahlteiler (31 - 33) aufweist, wobei der erste Strahlteiler (33) gemusterte Strahlen von dem ersten und von dem zweiten separaten räumlichen Lichtmodulator bündelt, um einen ersten gebündelten Strahl zu bilden, und wobei der zweite Strahlteiler (32) einen gemusterten Strahl von dem dritten separaten räumlichen Lichtmodulator mit dem ersten gebündelten Strahl bündelt, und einen zweiten gebündelten Strahl zu bilden, und wobei der dritte Strahlteiler einen gemusterten Strahl von dem vierten separaten räumlichen Lichtmodulator mit dem zweiten gebündelten Strahl bündelt, um einen dritten gebündelten Stahl zu bilden, der von dem Projektionssystem auf das Substrat projiziert wird.

5. Abbildungsvorrichtung nach Anspruch 1, 2 oder 3, bei der die programmierbare Musteraufbringungseinrichtung (PM) erste bis vierte separate räumliche Lichtmodulatoren aufweist und die Bündelungseinrichtung erste bis dritte Strahlteiler (81-83) aufweist, wobei der erste Strahlteiler (82) gemusterte Strahlen von dem ersten und von dem zweiten separaten räumlichen Lichtmodulator bündelt, um einen ersten gebündelten Strahl zu bilden, um wobei der zweite Strahlteiler (83) gemusterte Strahlen von dem dritten und von dem vierten separaten räumlichen Lichtmodulator bündelt, um einen zweiten gebündelten Strahl zu bilden, und wobei der dritte Strahlteiler (81) den ersten gebündelten Strahl mit dem zweiten gebündelten Strahl bündelt, um einen dritten gebündelten Strahl zu bilden, der von dem Projektionssystem auf das Substrat projiziert wird.

6. Abbildungsvorrichtung nach Anspruch 1, 2 oder 3, bei der die separaten räumlichen Lichtmodulatoren um einen imaginären Kreis herum und parallel zu der Objektebene angeordnet sind und die separaten optischen Kanäle jeweils ein optisches System (55, 56) mit einer optischen Achse, die im Allgemeinen radial zu dem imaginären Kreis verläuft, sowie einen Klappspiegel (51, 54) aufweisen zum Lenken eines von dem optischen System ausgegebenen Strahls derart, dass er die Objektebene kreuzt.

7. Abbildungsvorrichtung nach Anspruch 1, 2 oder 3, bei der die Bündelungseinrichtung einen 3-Wege-Teilstrahler (63) sowie zwei Klappspiegel (61, 62) aufweist.

8. Abbildungsvorrichtung nach einem der vorhergehenden Ansprüche, bei der jeder separate räumliche Lichtmodulator eine Reihe von individuell steuerbaren, die Strahlung modulierende Vorrichtungen aufweist.

9. Abbildungsvorrichtung nach Anspruch 8, bei der die Vielzahl separater räumlicher Lichtmodulatoren in gestapelter Anordnung auf einer Trägerplatte befestigt sind.

10. Abbildungsvorrichtung nach einem der Ansprüche 8 bis 7, bei der jeder separate räumliche Lichtmodulator eine Trägerplatte aufweist, auf der eine Vielzahl separater Anordnungen von individuell steuerbaren, die Strahlung modulierende Vorrichtungen befestigt sind, wobei die separaten Anordnungen in gestapelter Anordnung befestigt sind.

11. Abbildungsvorrichtung nach Anspruch 8, 9 oder 10, bei der jede individuell steuerbare, die Strahlung modulierende Vorrichtung einen bewegbaren Spiegel oder ein Pixel einer Flüssigkristallvorrichtung aufweist.

12. Abbildungsvorrichtung nach einem der vorhergehenden Ansprüche, des Weiteren umfassend eine Einrichtung, die das Substrat in einer ersten Richtung (Y) während der Belichtung eines Zielabschnittes scannt, und bei der die Bündelungseinrichtung und das Projektionssystem dafür ausgebildet sind, Bilder der Vielzahl separater räumlicher Lichtmodulatoren auf das Substrat in gestapelter Anordnung mit zumindest einer ersten und einer zweiten Reihe (R1, R2), die längs einer zweiten Richtung senkrecht zu der ersten Richtung verlaufen, zu projizieren, wobei die Länge der Bilder längs der zweiten Richtung größer als die Zwischenräume ist und die Bilder längs der zweiten Reihe sich, längs der ersten Richtung, hinter den Zwischenräumen der ersten Reihe befinden.

13. Abbildungsvorrichtung nach Anspruch 12, bei der die gestapelte Anordnung ferner eine dritte und eine vierte Reihe von Bildern (R3, R4) aufweist, wobei die dritte Reihe der Bilder, längs der ersten Richtung, hinter der zweiten Reihe und längs der zweiten Richtung von der ersten Reihe versetzt um einen Versatz, der geringer als die Länge von einem der Bilder längs der zweiten Richtung ist, angeordnet sind, und wobei die vierte Reihe der Bilder, längs der ersten Richtung, hinter der dritten Reihe und längs der zweiten Richtung von der zweiten Reihe versetzt um den ersten Versatz angeordnet sind.

14. Abbildungsvorrichtung nach Anspruch 12 oder 13, bei der jedes Bild der Vielzahl separater Musteraufbringungs-Teilelemente selbst eine gestapelte Anordnung von Bildern separater Anordnungen von individuell steuerbaren, die Strahlung modulierende Vorrichtungen aufweist.

15. Verfahren zum Herstellen einer Vorrichtung mit den Schritten:
- Bereitstellen eines Substrats (W), das zumindest teilweise von einer Schicht aus strahlungsempfindlichen Material überzogen ist;
- Bereitstellen eines Projektionsstrahls (P3) aus Strahlung unter Verwendung eines Strahlungssystems;
- Verwenden einer programmierbaren Musteraufbringungseinrichtung (PM), um den Querschnitt des Projektionsstrahls mit einem Muster zu versehen;
- Projizieren des gemusterten Strahls aus Strahlung auf einen Zielabschnitt der Schicht aus strahlungsempfindlichem Material,
**dadurch gekennzeichnet, dass** die programmierbare Musteraufbringungseinrichtung (PM) eine Vielzahl separater räumlicher Lichtmodulatoren (SLM1 - SLM4) aufweist, die jeweils dazu verwendet werden, einen gemusterten Teilstrahl zu erzeugen, und dass die Vielzahl gemusterter Teilstrahlen unter Verwendung eines Strahlteilers zu einem einzelnen gemusterten Bild auf dem Substrat gebündelt werden, das größer als das Bild von einem der räumlichen Lichtmodulatoren ist.

## Revendications

1. Appareil d'imagerie comportant :
- un système de rayonnement (IL) pour fournir un faisceau de projection de rayonnement ;
- des moyens de mise en forme programmables (PM), les moyens de mise en forme servant à mettre en forme le faisceau de projection conformément à un motif voulu ;
- une table de substrat (WT) pour supporter un substrat ;
- un système de projection (PL) pour projeter le faisceau mis en forme sur une partie cible du substrat,
**caractérisé en ce que** :
- les moyens de mise en forme programmables comportent une pluralité de modulateurs spatiaux de lumière séparés (SLM1, etc.), dont chacun est utilisé pour produire un sous-faisceau mis en forme ; et
- l'appareil comporte des moyens de combinaison (CM) comportant un séparateur de faisceau pour combiner la pluralité de sous-faisceaux mis en forme en une seule image mise en forme qui est plus grande que l'image de l'un quelconque des modulateurs spatiaux de lumière.

2. Appareil d'imagerie selon la revendication 1, dans lequel lesdits moyens de combinaison (CM) comportent une pluralité de canaux optiques séparés, un pour chacun desdits modulateurs spatiaux de lumière séparés, pour projeter une image d'un modulateur respectif desdits modulateurs spatiaux de lumière séparés dans un plan objet dudit système de projection.

3. Appareil d'imagerie selon la revendication 2, dans lequel ladite pluralité de canaux optiques séparés sont agencés pour projeter des images réduites desdits modulateurs spatiaux de lumière séparés.

4. Appareil d'imagerie selon la revendication 1, 2 ou 3, dans lequel lesdits moyens de mise en forme programmables (PM) comportent des premier à quatrième modulateurs spatiaux de lumière séparés (SLM1 à SLM4) et lesdits moyens de combinaison comportent des premier à troisième séparateurs de faisceau (31 à 33), ledit premier séparateur de faisceau (33) combinant des faisceaux mis en forme provenant desdits premier et deuxième modulateurs spatiaux de lumière séparés pour former un premier faisceau combiné, ledit deuxième séparateur de faisceau (32) combinant un faisceau mis en forme provenant dudit troisième modulateur spatial de lumière séparé avec ledit premier faisceau combiné pour former un deuxième faisceau combiné et ledit troisième séparateur de faisceau combinant un faisceau combiné provenant dudit quatrième modulateur spatial de lumière séparé avec ledit deuxième faisceau combiné pour former un troisième faisceau combiné qui est projeté sur ledit substrat par ledit système de projection.

5. Appareil d'imagerie selon la revendication 1, 2 ou 3, dans lequel lesdits moyens de mise en forme programmables (PM) comportent des premier à quatrième modulateurs spatiaux de lumière séparés et lesdits moyens de combinaison comportent des premier à troisième séparateurs de faisceau (81 à 83), ledit premier séparateur de faisceau (82) combinant des faisceaux mis en forme provenant desdits premier et deuxième modulateurs spatiaux de lumière séparés pour former un premier faisceau combiné, ledit deuxième séparateur de faisceau (83) combinant des faisceaux mis en forme provenant desdits troisième et quatrième modulateurs spatiaux de lumière séparés pour former un deuxième faisceau combiné, et ledit troisième séparateur de faisceau (81) combinant ledit premier faisceau combiné avec ledit deuxième faisceau combiné pour former un troisième faisceau combiné qui est projeté sur ledit substrat par ledit système de projection.

6. Appareil d'imagerie selon la revendication 1, 2 ou 3, dans lequel lesdits modulateurs spatiaux de lumière séparés sont agencés autour d'un cercle imaginaire parallèle audit plan objet et lesdits canaux optiques séparés comportent chacun un système optique (55, 56) ayant un axe optique s'étendant de manière générale radialement par rapport audit cercle imaginaire et un miroir pliable (51, 54) pour diriger une sortie de faisceau par ledit système optique pour qu'elle recoupe ledit plan objet.

7. Appareil d'imagerie selon la revendication 1, 2 ou 3, dans lequel lesdits moyens de combinaison comportent un séparateur de faisceau à trois voies (63) et deux miroirs rabattables (61, 62).

8. Appareil d'imagerie selon l'une quelconque des revendications précédentes, dans lequel chaque modulateur spatial de lumière séparé comporte un réseau de dispositifs de modulation de rayonnement pouvant être commandés individuellement.

9. Appareil d'imagerie selon la revendication 8, dans lequel ladite pluralité de modulateurs spatiaux de lumière séparés sont montés en un réseau à décalage sur une plaque de support.

10. Appareil d'imagerie selon l'une quelconque des revendications 1 à 7, dans lequel chacun desdits modulateurs spatiaux de lumière séparés comporte une plaque de support ayant, montée sur celle-ci une pluralité de réseaux séparés constitués de dispositifs de modulation de rayonnement pouvant être commandés individuellement, lesdits réseaux séparés étant montés en un réseau à décalage.

11. Appareil d'imagerie selon la revendication 8, 9 ou 10, dans lequel chacun desdits dispositifs de modulation de rayonnement pouvant être commandés individuellement comporte un miroir mobile ou un pixel d'un dispositif à cristaux liquides.

12. Appareil d'imagerie selon l'une quelconque des revendications précédentes, comportant de plus des moyens pour balayer ledit substrat dans une première direction (Y) pendant une exposition d'une partie cible et dans lequel lesdits moyens de combinaison et ledit système de projection sont adaptés pour projeter des images de ladite pluralité de modulateurs spatiaux de lumière séparés sur ledit substrat dans un réseau à décalage ayant au moins des première et deuxième rangées (R1, R2) s'étendant dans une seconde direction perpendiculaire à ladite première direction, les longueurs desdites images dans ladite seconde direction étant plus grandes que les espaces entre celles-ci et les images de ladite deuxième rangée étant placées derrière les espaces de ladite première rangée dans ladite première direction.

13. Appareil d'imagerie selon la revendication 12, dans lequel ledit réseau à décalage comporte de plus des troisième et quatrième rangées d'images (R3, R4), ladite troisième rangée d'images étant derrière ladite deuxième rangée dans ladite première direction et décalée à partir de ladite première rangée dans ladite seconde direction d'une première distance de décalage plus petite que la longueur dans ladite seconde direction de l'une desdites images, et ladite quatrième rangée d'images étant derrière ladite troisième rangée dans ladite première direction et décalée, à partir de ladite deuxième rangée, dans ladite seconde direction de ladite première distance de décalage.

14. Appareil d'imagerie selon la revendication 12 ou 13, dans lequel chacune desdites images de ladite pluralité de sous-éléments de mise en forme séparés elle-même comporte un réseau étagé d'images de réseaux séparés de dispositifs de modulation de rayonnement pouvant être commandés individuellement.

15. Procédé de fabrication de dispositifs comportant les étapes de :
- fournir un substrat (W) qui est au moins partiellement revêtu d'une couche de matériau sensible à un rayonnement ;
- fournir un faisceau de projection (P3) d'un rayonnement en utilisant un système de rayonnement ;
- utiliser des moyens de mise en forme programmables (PM) pour imposer au faisceau de projection un motif dans sa section transversale ;
- projeter le faisceau de rayonnement mis en forme sur une partie cible de la couche de matériau sensible à un rayonnement,
**caractérisé en ce que** les moyens de mise en forme programmables (PM) comportent une pluralité de modulateurs spatiaux de lumière séparés (SLM1 à SLM4), dont chacun est utilisé pour produire un sous-faisceau mis en forme, et **en ce que** la pluralité de sous-faisceaux mis en forme est combinée en utilisant un séparateur de faisceau en une seule image mise en forme sur le substrat, qui est plus grande que l'image de l'un quelconque des modulateurs spatiaux de lumière.
